# EUROPEAN PATENT APPLICATION

(11) **EP 4 586 568 A1**
(43) Date of publication of application: **16.07.2025**
(21) Application number: 22961680.0
(22) Date of filing: 11.10.2022
(51) Int. Cl.: H04L 27/00, H04L 1/00, G06F 11/00

(54) **METHOD FOR DETERMINING CYCLIC REDUNDANCY CHECK (CRC) BIT, AND COMMUNICATION METHOD AND APPARATUS**

(71) Applicant: Huawei Technologies Co., Ltd., Shenzhen, Guangdong 518129 (CN)
(72) Inventor: QIN, Kangjian, Shenzhen, Guangdong 518129 (CN); ZHANG, Huazi, Shenzhen, Guangdong 518129 (CN); TONG, Jiajie, Shenzhen, Guangdong 518129 (CN); WANG, Jun, Shenzhen, Guangdong 518129 (CN)
(74) Representative: Grünecker Patent- und Rechtsanwälte PartG mbB
(86) International application number: PCT/CN2022/124663
(87) International publication number: WO 2024/077486

(57) **Abstract**

A cyclic redundancy check bit determining method and apparatus, and a communication method and apparatus are provided. The cyclic redundancy check bit determining method includes: obtaining an information bit; determining a check bit length L based on a first correspondence; and determining a first check bit based on a first CRC polynomial, where L is a natural number, the first correspondence includes a correspondence among code length information of to-be-transmitted data, length information of the information bit, and a check bit length, the to-be-transmitted data includes the information bit, a highest power of terms in the first CRC polynomial is Lmax, Lmax is a positive integer, and Lmax is greater than or equal to L. A check bit with a length adapted to a code length and a code rate may be flexibly generated, to improve communication performance.

## Description

### TECHNICAL FIELD

This application relates to the field of mobile communication technologies, and in particular, to a cyclic redundancy check bit determining method and apparatus, and a communication method and apparatus.

### BACKGROUND

In a new radio (new radio, NR) system, CRC encoding is performed on an information bit (bit) in a cyclic redundancy check (cyclic redundancy check, CRC) code encoding process, and then subsequent processing is performed on a bit (namely, a CRC codeword) obtained through CRC encoding. The CRC codeword includes the information bit and a check bit. For example, in a CRC-aided polar code (CRC-aided polar, CA-polar) encoding process, the CRC codeword is interleaved, and then polar code encoding is performed on a sequence obtained through interleaving.

A length of an optimal check bit of a CRC code changes with a code length and a code rate. However, in an existing CRC encoding scheme, one CRC polynomial supports only one check bit length, and a check bit with a proper length cannot be flexibly selected based on the code length and the code rate. Consequently, communication performance is reduced.

### SUMMARY

This application provides a cyclic redundancy check bit determining method and apparatus, and a communication method and apparatus, to flexibly determine a CRC check bit and improve communication performance.

According to a first aspect, this application provides a cyclic redundancy check bit determining method, to reduce complexity of channel estimation at a receive end and improve performance of the receive end. The method may be implemented by a first communication apparatus. The first communication apparatus may be a terminal device, a network device, a component in the network device, or a component in the terminal device. The component in this application may include, for example, at least one of a chip, a chip system, a processor, a transceiver, a processing unit, or a transceiver unit. For example, an execution body is the first communication apparatus. The method may be implemented by using the following steps: The first communication apparatus obtains an information bit. The first communication apparatus may further determine, based on a first correspondence, that a check bit length is L. L is a natural number, the first correspondence includes a correspondence among code length information of to-be-transmitted data, length information of the information bit, and the check bit length, and the to-be-transmitted data includes the information bit. The first communication apparatus determines a first check bit based on a first CRC polynomial. A highest power of terms in the first CRC polynomial is Lmax, Lmax is a positive integer and is greater than or equal to L, and a length of the first check bit is L.

Based on the method, the first communication apparatus may determine the corresponding check bit length L based on a code length of the to-be-transmitted data in which the information bit is located and a length of the information bit, and generate the first check bit with the length of L based on the first CRC polynomial. Therefore, a check bit with a length adapted to a code length and a code rate can be flexibly generated, to improve communication performance.

In a possible implementation, the first communication apparatus may determine a second check bit based on the first CRC polynomial. A length of the second check bit is Lmax. The first communication apparatus may further determine the first check bit based on the second check bit.

Based on this implementation, the first communication apparatus may determine, based on the first CRC polynomial, the second check bit whose length is Lmax, and then determine, based on the second check bit, the first check bit whose length is L, to flexibly determine the first check bit.

In a possible implementation, the first communication apparatus may determine a second CRC polynomial based on the first CRC polynomial. A highest power of the second CRC is L. The first communication apparatus may further determine the first check bit based on the second CRC polynomial.

Based on this implementation, the first communication apparatus may determine the second CRC polynomial based on the first CRC polynomial, and determine, based on the second CRC polynomial, the first check bit whose length is L, to flexibly determine the first check bit.

In a possible implementation, the first CRC polynomial includes a term whose power is L, and terms in the second CRC polynomial include a term whose power is not greater than L in the first CRC polynomial. Therefore, the second CRC polynomial can be flexibly determined.

In a possible implementation, the first CRC polynomial does not include a term whose power is L, and terms in the second CRC polynomial include a term whose power is L and at least one term whose power is less than L in the first CRC polynomial. Therefore, the second CRC polynomial can be flexibly determined. Optionally, the first communication apparatus may determine the second CRC polynomial based on a correspondence between L and the second CRC polynomial.

In a possible implementation, the first communication apparatus may delete at least one term other than the term whose power is L from the second CRC polynomial, to obtain a third polynomial. The second CRC polynomial is a reducible polynomial, and the third polynomial is not a reducible polynomial. The first communication apparatus may further determine the first check bit based on the third polynomial.

Based on this implementation, the first communication apparatus may ensure that the first check bit is generated based on an irreducible CRC polynomial, to improve an error detection capability.

In a possible implementation, the first communication apparatus may further obtain first indication information. The first indication information indicates the first correspondence.

Based on this implementation, the first communication apparatus may learn of the first correspondence based on the obtained first indication information. For example, the first indication information is from the network device. In addition, the first communication apparatus may further learn of the first correspondence through preconfiguration, predefinition, or definition in a protocol, or the like.

In a possible implementation, the first communication apparatus may further send second indication information to a second communication apparatus. The second indication information indicates that the check bit length is L.

Based on this implementation, the first communication apparatus may indicate a value of L to the second communication apparatus, so that the second communication apparatus flexibly determines L. Optionally, the second communication apparatus may determine the value of L in a manner the same as a manner in which the first communication apparatus determines the value of L.

According to a second aspect, this application provides a communication method, to reduce complexity of channel estimation at a receive end and improve performance of the receive end. The method may be implemented by a first device. The first device may be a terminal device, a network device, a component in the network device, or a component in the terminal device. The component in this application may include, for example, at least one of a chip, a chip system, a processor, a transceiver, a processing unit, or a transceiver unit. For example, an execution body is the first device. The method may be implemented by using the following steps: The first device determines second indication information. The second indication information indicates a check bit length L, L is a natural number, L is determined based on a first correspondence, and the first correspondence includes a correspondence among code length information of to-be-transmitted data including an information bit, length information of the information bit, and the check bit length. The first device may further send the second indication information to a second device.

Based on the second aspect, the first device may determine the corresponding check bit length L based on a code length of the to-be-transmitted data in which the information bit is located and a length of the information bit, and indicate the check bit length L to the second device based on the second indication information, so that the second device learns of L. Therefore, the second device may flexibly generate a check bit with a length adapted to a code length and a code rate, to improve communication performance.

In a possible implementation, the first device may further determine a first check bit based on a first CRC polynomial. A length of the first check bit is L, a highest power of terms in the first CRC polynomial is Lmax, Lmax is a positive integer, and Lmax is greater than or equal to L.

Based on this implementation, the first device may further obtain the first check bit with the length of L based on the first CRC polynomial. Therefore, a check bit with a length adapted to a code length and a code rate can be flexibly generated, to improve communication performance.

In a possible implementation, the first device may determine a second check bit based on the first CRC polynomial. A length of the second check bit is Lmax. The first device may further determine the first check bit based on the second check bit.

Based on this implementation, the first device may determine, based on the first CRC polynomial, the second check bit whose length is Lmax, and then determine, based on the second check bit, the first check bit whose length is L, to flexibly determine the first check bit.

In a possible implementation, the first device may determine a second CRC polynomial based on the first CRC polynomial. A highest power of the second CRC is L. The first device may further determine the first check bit based on the second CRC polynomial.

Based on this implementation, the first device may determine the second CRC polynomial based on the first CRC polynomial, and determine, based on the second CRC polynomial, the first check bit whose length is L, to flexibly determine the first check bit.

In a possible implementation, the first CRC polynomial includes a term whose power is L, and terms in the second CRC polynomial include a term whose power is not greater than L in the first CRC polynomial. Therefore, the second CRC polynomial can be flexibly determined.

In a possible implementation, the first CRC polynomial does not include a term whose power is L, and terms in the second CRC polynomial include a term whose power is L and at least one term whose power is less than L in the first CRC polynomial. Therefore, the second CRC polynomial can be flexibly determined. Optionally, the first device may determine the second CRC polynomial based on a correspondence between L and the second CRC polynomial.

In a possible implementation, the first device may delete at least one term other than the term whose power is L from the second CRC polynomial, to obtain a third polynomial. The second CRC polynomial is a reducible polynomial, and the third polynomial is not a reducible polynomial. The first device may further determine the first check bit based on the third polynomial.

Based on this implementation, the first device may ensure that the first check bit is generated based on an irreducible CRC polynomial, to improve an error detection capability.

In a possible implementation, the first device may further obtain first indication information. The first indication information indicates the first correspondence.

Based on this implementation, the first device may learn of the first correspondence based on the obtained first indication information. For example, the first indication information is from the network device. In addition, the first device may further learn of the first correspondence through preconfiguration, predefinition, or definition in a protocol, or the like.

According to a third aspect, this application provides a communication method, to reduce complexity of channel estimation at a receive end and improve performance of the receive end. The method may be implemented by a second device. The second device may be a terminal device, a network device, a component in the network device, or a component in the terminal device. The component in this application may include, for example, at least one of a chip, a chip system, a processor, a transceiver, a processing unit, or a transceiver unit. For example, an execution body is the second device. The method may be implemented by using the following steps: The second device obtains second indication information. The second indication information indicates a check bit length L, and L is a natural number. The second device may further determine a first check bit based on a first cyclic redundancy check CRC polynomial. A length of the first check bit is L, a highest power of terms in the first CRC polynomial is Lmax, Lmax is a positive integer, and Lmax is greater than or equal to L.

Based on the third aspect, the second device may determine the check bit length L based on the second indication information, and generate the first check bit with the length of L based on the first CRC polynomial. Therefore, the second device may flexibly generate a check bit with a length adapted to a code length and a code rate, to improve communication performance.

In a possible implementation, the second device may determine a second check bit based on the first CRC polynomial. A length of the second check bit is Lmax. The second device may further determine the first check bit based on the second check bit.

Based on this implementation, the second device may determine, based on the first CRC polynomial, the second check bit whose length is Lmax, and then determine, based on the second check bit, the first check bit whose length is L, to flexibly determine the first check bit.

In a possible implementation, the second device may determine a second CRC polynomial based on the first CRC polynomial. A highest power of the second CRC is L. The second device may further determine the first check bit based on the second CRC polynomial.

Based on this implementation, the second device may determine the second CRC polynomial based on the first CRC polynomial, and determine, based on the second CRC polynomial, the first check bit whose length is L, to flexibly determine the first check bit.

In a possible implementation, the first CRC polynomial includes a term whose power is L, and terms in the second CRC polynomial include a term whose power is not greater than L in the first CRC polynomial. Therefore, the second CRC polynomial can be flexibly determined.

In a possible implementation, the first CRC polynomial does not include a term whose power is L, and terms in the second CRC polynomial include a term whose power is L and at least one term whose power is less than L in the first CRC polynomial. Therefore, the second CRC polynomial can be flexibly determined. Optionally, the second device may determine the second CRC polynomial based on a correspondence between L and the second CRC polynomial.

In a possible implementation, the second device may delete at least one term other than the term whose power is L from the second CRC polynomial, to obtain a third polynomial. The second CRC polynomial is a reducible polynomial, and the third polynomial is not a reducible polynomial. The second device may further determine the first check bit based on the third polynomial.

Based on this implementation, the second device may ensure that the first check bit is generated based on an irreducible CRC polynomial, to improve an error detection capability.

In a possible implementation, the second device may further obtain first indication information. The first indication information indicates the first correspondence.

Based on this implementation, the second device may learn of the first correspondence based on the obtained first indication information. For example, the first indication information is from the network device. In addition, the second device may further learn of the first correspondence through preconfiguration, predefinition, or definition in a protocol, or the like.

According to a fourth aspect, a communication apparatus is provided. The apparatus may implement the methods separately performed by a first terminal apparatus, a first device, or a second device in any one of the first aspect to the third aspect and the possible implementations of the first aspect to the third aspect. The apparatus is, for example, the first terminal apparatus.

In an optional implementation, the apparatus may include a one-to-one corresponding module for performing the method/operation/step/action described in any one of the first aspect to the third aspect and the possible implementations of the first aspect to the third aspect. The module may be implemented by a hardware circuit, software, or a hardware circuit in combination with software. In an optional implementation, the apparatus includes a processing unit (sometimes also referred to as a processing module) and a communication unit (sometimes also referred to as a communication module, a transceiver module, or a transceiver unit). The communication unit can implement a sending function and a receiving function. When the communication unit implements the sending function, the communication unit may be referred to as a sending unit (sometimes also referred to as a sending module). When the communication unit implements the receiving function, the communication unit may be referred to as a receiving unit (sometimes also referred to as a receiving module). The sending unit and the receiving unit may be a same functional module, and the functional module can implement the sending function and the receiving function. Alternatively, the sending unit and the receiving unit may be different functional modules, and the transceiver unit is a collective name of these functional modules.

For another example, the apparatus includes a processor, coupled to a memory, and is configured to execute instructions in the memory, to implement the method described in any one of the first aspect to the third aspect and the possible implementations of the first aspect to the third aspect. Optionally, the apparatus further includes another component, for example, an antenna, an input/output module, a transceiver, or a communication interface. These components may be hardware, software, or a combination of software and hardware.

According to a fifth aspect, a computer-readable storage medium is provided. The computer-readable storage medium is configured to store a computer program or instructions, and when the computer program or the instructions are run, the method in any possible implementation of the first aspect to the third aspect is implemented.

According to a sixth aspect, a computer program product including instructions is provided. When the computer program product is run on a computer, the method in any possible implementation of the first aspect to the third aspect is implemented.

According to a seventh aspect, a chip system is provided. The chip system includes a logic circuit (which may alternatively be understood as that the chip system includes a processor, and the processor may include a logic circuit, and the like), and may further include an input/output interface. The input/output interface may be configured to receive a message, or may be configured to send a message. The input/output interface may be a same interface. In other words, a same interface can implement both a sending function and a receiving function. Alternatively, the input/output interface includes an input interface and an output interface. The input interface is configured to implement a receiving function, that is, configured to receive a message. The output interface is configured to implement a sending function, that is, configured to send a message. The logic circuit may be configured to perform an operation other than a receiving/sending function in any one of the first aspect to the third aspect and the possible implementations of the first aspect to the third aspect. The logic circuit may be further configured to transmit a message to the input/output interface, or receive a message from another communication apparatus through the input/output interface. The chip system may be configured to implement the method in any possible implementation of the first aspect to the third aspect. The chip system may include a chip, or may include a chip and another discrete component.

Optionally, the chip system may further include a memory, and the memory may be configured to store instructions. The logic circuit may invoke the instructions stored in the memory to implement a corresponding function.

According to an eighth aspect, a communication system is provided. The communication system may include a first communication apparatus and at least one of a network device and a second communication apparatus. The first communication apparatus may be configured to perform the method in any one of the first aspect and the possible implementations of the first aspect. Alternatively, the communication system may include a first device and a second device. The first device may be configured to perform the method in any one of the second aspect and the possible implementations of the second aspect, and the second device may be configured to perform the method in any one of the third aspect and the possible implementations of the third aspect.

For technical effects brought by the second aspect to the eighth aspect, refer to the descriptions of the first aspect. Details are not described herein again.

### BRIEF DESCRIPTION OF DRAWINGS

FIG. 1 is a diagram of an architecture of a wireless communication system according to an embodiment of this application;
FIG. 2 is a diagram of a radio signal transmission process;
FIG. 3 is a diagram of a CA-polar encoding process;
FIG. 4 is a schematic flowchart of a cyclic redundancy check bit determining method according to an embodiment of this application;
FIG. 5 shows a correspondence table among N, K, and L according to an embodiment of this application;
FIG. 6 shows another correspondence table among N, K, and L according to an embodiment of this application;
FIG. 7 shows another correspondence table among N, K, and L according to an embodiment of this application;
FIG. 8 shows a correspondence table among N, K, and a second CRC polynomial according to an embodiment of this application;
FIG. 9 shows another correspondence table among N, K, and a second CRC polynomial according to an embodiment of this application;
FIG. 10 shows another correspondence table among N, K, and a second CRC polynomial according to an embodiment of this application;
FIG. 11 shows another correspondence table among N, K, and a second CRC polynomial according to an embodiment of this application;
FIG. 12 shows a possible first CRC polynomial whose highest power is 11 according to an embodiment of this application;
FIG. 13 shows a possible first CRC polynomial whose highest power is 6 according to an embodiment of this application;
FIG. 14 is a schematic flowchart of a communication method according to an embodiment of this application;
FIG. 15 is a diagram of a structure of a communication apparatus according to an embodiment of this application;
FIG. 16 is a diagram of a structure of another communication apparatus according to an embodiment of this application; and
FIG. 17 is a diagram of a structure of another communication apparatus according to an embodiment of this application.

### DESCRIPTION OF EMBODIMENTS

Embodiments of this application provide a cyclic redundancy check bit determining method and apparatus. The method and the apparatus are based on a same inventive concept. Because the method and the apparatus have a similar problem-resolving principle, for implementations of the apparatus and the method, refer to each other, and no repeated description is provided. In descriptions of embodiments of this application, "and/or" describes an association relationship between associated objects and indicates that three relationships may exist. For example, A and/or B may indicate the following three cases: Only A exists, both A and B exist, and only B exists. The character "/" usually indicates an "or" relationship between the associated objects. In this application, "at least one" means one or more, and "a plurality of" means two or more. In addition, it should be understood that in descriptions of this application, terms such as "first" and "second" are merely used for distinguishing and description, but should not be understood as indicating or implying relative importance, or should not be understood as indicating or implying a sequence.

The method provided in embodiments of this application may be applied to a 4th generation (4th generation, 4G) communication system, for example, a long term evolution (long term evolution, LTE) communication system; or may be applied to a 5th generation (5th generation, 5G) communication system, for example, a 5G new radio (new radio, NR) communication system; or may be applied to various future communication systems, for example, a 6th generation (6th generation, 6G) communication system. The method provided in embodiments of this application may be further applied to three application scenarios, namely, an enhanced mobile broadband (enhanced mobile broadband, eMBB), ultra-reliable low-latency communication (ultra-reliable low-latency communication, URLLC), and enhanced machine-type communication (enhanced machine-type communication, eMTC) of a narrowband internet of things system (narrowband internet of things, NB-IoT), a global system for mobile communications (global system for mobile communications, GSM), an enhanced data rate for GSM evolution system (enhanced data rate for GSM evolution, EDGE), a wideband code division multiple access system (wideband code division multiple access, WCDMA), a code division multiple access 2000 system (code division multiple access, CDMA2000), a time division-synchronous code division multiple access system (time division-synchronous code division multiple access, TD-SCDMA), or a next-generation 5G mobile communication system. The method provided in embodiments of this application may be further applied to a satellite communication system. The satellite communication system may be integrated with the foregoing communication system.

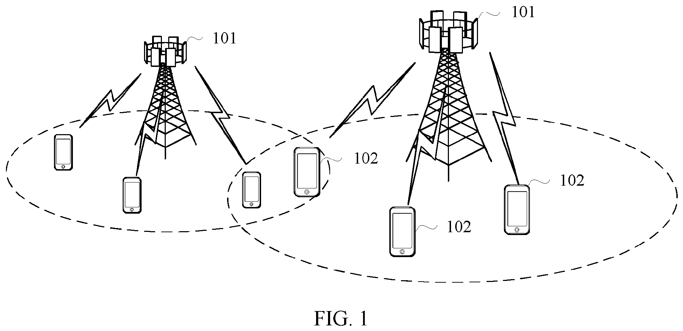

For ease of understanding embodiments of this application, an application scenario used in this application is described by using a communication system architecture shown in FIG. 1 as an example. As shown in FIG. 1, the communication system includes a network device 101 and a terminal device 102. The apparatus provided in embodiments of this application may be applied to the network device 101 or the terminal device 102. It may be understood that FIG. 1 shows only one possible communication system architecture to which embodiments of this application may be applied. In another possible scenario, the communication system architecture may alternatively include another device.

The network device 101 is a node in a radio access network (radio access network, RAN), and may also be referred to as a base station or a RAN node (or device). Currently, some examples of the access network device are a gNB/NR-NB, a transmission reception point (transmission reception point, TRP), an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB or a home NodeB, HNB), a baseband unit (baseband unit, BBU), a wireless fidelity (wireless fidelity, Wi-Fi) access point (access point, AP), a satellite device, a network device in a 5G communication system, or a network device in a possible future communication system. Alternatively, the network device 101 may be another device that has a network device function. For example, the network device 101 may alternatively be a device that assumes the network device function in device-to-device (device-to-device, D2D) communication, internet of vehicles communication, or machine-to-machine communication. Alternatively, the network device 101 may be a network device in a possible future communication system.

In some deployments, the gNB may include a central unit (central unit, CU) and a DU. The gNB may further include a radio unit (radio unit, RU). The CU implements some functions of the gNB, and the DU implements some functions of the gNB. For example, the CU implements functions of a radio resource control (radio resource control, RRC) layer and a packet data convergence protocol (packet data convergence protocol, PDCP) layer, and the DU implements functions of a radio link control (radio link control, RLC) layer, a media access control (media access control, MAC) layer, and a physical (physical, PHY) layer. Information at the RRC layer eventually becomes information at the PHY layer, or is converted from the information at the PHY layer. Therefore, in the architecture, higher layer signaling such as RRC layer signaling or PHCP layer signaling may also be considered as being sent by the DU or sent by the DU and the RU. It may be understood that the network device may be a CU node, a DU node, or a device including a CU node and a DU node. In addition, the CU may be classified as a network device in an access network RAN, or the CU may be classified as a network device in a core network CN. This is not limited herein.

The terminal device 102 may also be referred to as user equipment (user equipment, UE), a mobile station (mobile station, MS), a mobile terminal (mobile terminal, MT), or the like, and is a device that provides a user with voice or data connectivity, or may be an internet of things device. For example, the terminal device includes a handheld device, a vehicle-mounted device, or the like that has a wireless connection function. Currently, the terminal device may be a mobile phone, a tablet computer, a laptop computer, a palmtop computer, a mobile internet device (mobile internet device, MID), a wearable device (for example, a smartwatch, a smart band, or a pedometer), a vehicle-mounted device (for example, a car, a bicycle, an electric car, an airplane, a ship, a train, or a high-speed rail), a virtual reality (virtual reality, VR) device, an augmented reality (augmented reality, AR) device, a wireless terminal in industrial control, a smart household device (for example, a refrigerator, a television, an air conditioner, or a meter), an intelligent robot, workshop equipment, a wireless terminal in self driving, a wireless terminal in remote surgery, a wireless terminal in smart grid (smart grid), a wireless terminal in transportation safety, a wireless terminal in smart city, a wireless terminal in smart home, a flight device (for example, an intelligent robot, a hot air balloon, an uncrewed aerial vehicle, or an airplane), or the like. The terminal device may alternatively be another device having a terminal function. For example, the terminal device may alternatively be a device assuming a terminal function in D2D communication. A terminal device with a wireless receiving/sending function and a chip that can be disposed in the terminal device are collectively referred to as the terminal device in this application.

The following describes in detail the method provided in embodiments of this application with reference to the communication system shown in FIG. 1.

To better understand the solutions provided in embodiments of this application, the following first describes some terms, concepts, or procedures in embodiments of this application.

### (1) Channel encoding

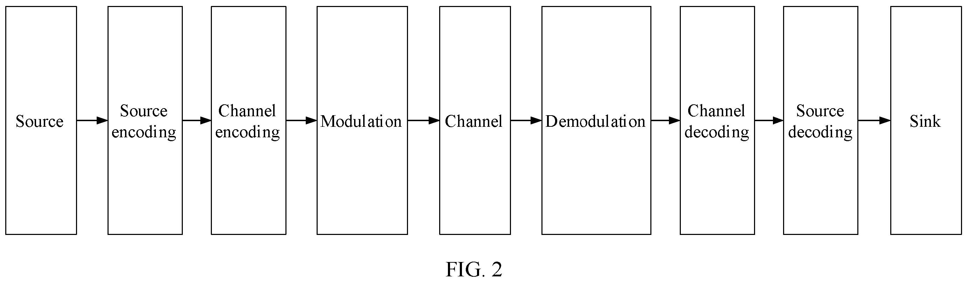

As shown in FIG. 2, a channel encoding part is located between source encoding and modulation, and is responsible for performing channel encoding on an information bit (or referred to as a bit stream) generated by a source, and after modulation, a modulation symbol is sent to a receive end through a noise channel for demodulation. After demodulation, the receive end performs channel decoding. A channel decoding part is located between demodulation and source decoding, and is responsible for restoring the information bit of the source.

In this application, a length of the information bit may be referred to as a payload length (payload size).

### (2) CRC encoding

CRC encoding is a manner of channel encoding. In a CRC encoding process, CRC encoding is performed on an information bit from a source, to obtain a CRC codeword. For example, a length of the information bit is K. The CRC codeword includes a K-bit information bit and an R-bit check bit (or referred to as a check code, a CRC code, or the like) concatenated after the K-bit information bit. That is, a length of the CRC codeword is K+R bits. K and R each are a positive integer.

For a CRC codeword whose check bit length is R, there is a CRC polynomial gCRC whose highest power is R. gCRC may be used to generate an R-bit check bit. Therefore, gCRC may be referred to as a generator polynomial of the check bit. In this application, the power may be replaced with an exponent, and the highest power may be replaced with a highest exponent. The generator polynomial may be determined by a transmit end and a receive end through negotiation, or may be determined through definition in a protocol, preconfiguration, predefinition, or the like. Therefore, the check bit length may be determined based on the polynomial.

The following describes a CRC check code generation process. It is assumed that a message polynomial is M(D). The message polynomial is determined based on a binary information bit that needs to be sent. For example, if a value of an X^{th} bit of the binary information bit is 1, a coefficient of a term whose power is X-1 in the polynomial is 1, and if a value of a Y^{th} bit of the binary bit is 0, a coefficient of a term whose power is Y-1 in the polynomial is 0, in other words, the polynomial does not include a term whose power is Y. X and Y each are a positive integer. To obtain a check bit, M(D) is shifted leftward by R bits. In other words, R is added to a power of each term. A polynomial is represented as M(D)*D^R. Herein, * represents a multiplication operation. A remainder obtained by dividing M(D)*D^R by the generator polynomial gCRC is the check bit.

For example, if a generator polynomial of the check bit is gCRCLmax=gCRC4=D^4+D+1, a binary representation of the generator polynomial is 10011, which includes a total of five bits. Herein, Lmax=4. That is, R=4. If a binary bit of a data sequence to be sent by the transmit end is 101011, which includes a total of six bits, the message polynomial is M(D)=D^5+D^3+D+1. Herein, ^ represents an exponential operation. Further, it can be learned that M(D)*D^5=D^9+D^7+D^5+D^4. A corresponding binary information bit obtained by dividing a binary bit 1010110000 corresponding to M(D)*D^5 by the polynomial gCRCLmax is 10011. That is, an R-bit remainder is obtained based on a modulo-2 algorithm. In this example, a bit sequence of the remainder is 0100, and the remainder is the check bit. Therefore, a bit stream of a CRC codeword obtained through CRC encoding is 1010110100. First 6 bits are original data 9 (namely, the information bit), and last 4 bits are the check bit. The transmit end may perform subsequent processing on the bit stream 1010110100 and send the bit stream. If no error occurs in a data transmission process, data that includes the check bit and that is received by the receive end can be exactly divided by the binary bit 10011 of the generator polynomial of the check bit. If an error occurs in a transmission process, data that includes the check bit and that is received by the receive end cannot be exactly divided by 10011. In this way, the receive end can identify a transmission error.

In this application, the transmit end and the receive end may respectively serve as a network device or a terminal device. It may be understood that in downlink communication, the network device is a transmit end, and the terminal device is a receive end; and in uplink communication, the terminal device is a transmit end, and the network device is a receive end. The network device may be a transmit end or a receive end. If the transmit end is a network device, the receive end is a terminal device. In this case, downlink communication is performed. If the transmit end is a terminal device, the receive end is a network device. In this case, uplink communication is performed. In addition, in this application, a case in which both the transmit end and the receive end are terminal devices is not excluded. In this case, D2D communication is performed between the transmit end and the receive end.

### (3) CA-polar encoding

In an NR system, an encoding scheme used by a transmit end is related to a bit length of a to-be-transmitted message. For an information bit whose length is 1 bit to 2 bits, a simplex code (simplex codes) is used. In other words, the information bit is mapped onto constellation points with a maximum Euclidean distance. For an information bit whose length is 3 bits to 11 bits, an LTE-Reed-Muller (LTE-RM) code is used. In this manner, a code distance is improved by using a mask sequence, and maximum likelihood (maximum likelihood, ML) performance is implemented in combination with fast Hadamard transform (fast hadamard transform, FHT) decoding. However, decoding complexity is still high in a case of ML performance. For an information bit of 12 bits to 19 bits, a parity-check polar code (parity-check polar code, PC-polar) is used. In this manner, a hardware implementation is simple, and a code distance of a short code is effectively improved. However, description of PC check construction is not concise enough. For an information bit of greater than or equal to 20 bits, CA-polar encoding is used.

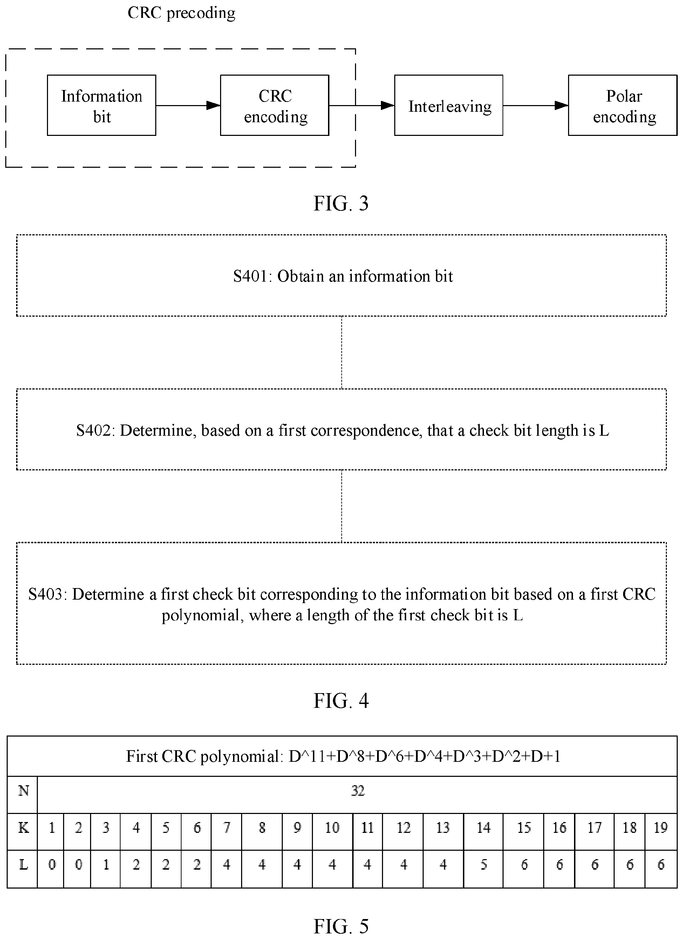

In CA-polar encoding, a CRC codeword is interleaved in addition to CRC encoding, and then polar encoding is performed on a CRC sequence obtained through interleaving. This process is shown in FIG. 3. An objective of interleaving is to disperse CRC check bits to different locations in a message sequence, and the CRC sequence obtained through interleaving can meet a requirement of early stopping in decoding. The sequence obtained through interleaving is sent to a polar encoder for encoding. It may be understood that processing steps shown in FIG. 3 are merely examples for description, are not used to limit a mandatory step to be performed during CA-polar encoding, and are not used to limit a mandatory encoding manner to be applied to the CRC check bit in this application. For example, after encoding is performed by using the polar encoder, a codeword obtained through encoding by the polar encoder may be further processed by using a rate matching module and an interleaver module.

### (4) Rate matching (rate matching)

A data block existing before encoding is referred to as a transport block (transport block, TB). Because a TB has a large quantity of bits, a transmit end usually splits one TB into a plurality of code blocks (code block, CB), and channel encoding is separately performed on each CB. Because a physical resource for transmitting a code block may be inconsistent with a physical time-frequency resource of a to-be-transmitted code block, bit retransmission or puncturing needs to be performed for the to-be-transmitted code block, to match a bearing capability of the physical time-frequency resource. This process is referred to as rate matching (rate matching). For a plurality of CBs on which channel encoding is performed, rate matching needs to be performed, and then processing such as interleaving and concatenation is performed. Then, the plurality of CBs are used as one physical data block (codeword) and are transmitted to a receive end.

It can be learned, based on descriptions of a process of generating the CRC check bit, that currently, a length of the CRC check bit is the same as a highest power of a generator polynomial of the check bit. In other words, one CRC polynomial supports only one CRC check length. However, when different code lengths and code rates are used, a length of a check bit with optimal performance may vary. Therefore, the transmit end and the receive end cannot flexibly select a check bit of a proper length based on a same CRC polynomial, and there is an increase in a block error rate (block error rate, BLER), an increase in a signal-to-noise ratio (signal to noise ratio, SNR) required to reach a required BLER, and/or the like. Consequently, communication performance deteriorates. In addition, if the transmit end and the receive end need to select a proper check bit, in the conventional technology, the transmit end and the receive end can select a proper check bit only by changing the CRC polynomial. Consequently, a system delay is increased, and communication performance deteriorates.

In view of this, an embodiment of this application provides a cyclic redundancy check bit determining method, to flexibly select a check bit length. In the method, a check bit length corresponding to code length information of to-be-transmitted data including an information bit and length information of the information bit may be determined based on the two pieces of information, and then a check bit of the length is generated based on a CRC polynomial, to determine a check bit of a flexible length.

The method may be implemented by a first communication apparatus. The first communication apparatus may be used as a transmit end and/or a receive end of the information bit. Correspondingly, an apparatus that transmits the information bit with the first communication apparatus may be referred to as a second communication apparatus. In other words, the first communication apparatus is a transmit end, and the second communication apparatus is a receive end; or the first communication apparatus is a receive end, and the second communication apparatus is a transmit end. The transmit end may flexibly generate, in the method, a check bit adapted to a code length and a code rate, and implement CRC encoding based on the check bit. Correspondingly, the receive end may generate a same check bit in a corresponding manner, to implement a check based on the check bit. With reference to the descriptions in this application, the transmit end may include a network device or a terminal device, and the receive end may include a network device or a terminal device.

With reference to the accompanying drawings, the following describes a cyclic redundancy check bit determining method provided in an embodiment of this application.

As shown in FIG. 4, when a first communication apparatus serves as an execution body, a cyclic redundancy check bit determining method provided in an embodiment of this application may include the following operations.

S401: The first communication apparatus obtains an information bit.

The information bit is a bit stream transmitted between a transmit end and a receive end.

For example, if the first communication apparatus is a transmit end of the information bit, the information bit may be an information bit obtained through source encoding. For another example, the first communication apparatus is a receive end of the information bit, and the information bit may be a decoded CRC codeword, including the information bit and a check bit.

Optionally, the first communication apparatus may further obtain first information and second information. The first information is code length information of to-be-transmitted data including the information bit. For example, a code length of the to-be-transmitted data including the information bit is 30 bits, 32 bits, or 40 bits. The to-be-transmitted data is data mapped onto a physical time-frequency resource. For example, in CA-polar encoding, the first information is mother code length information before rate matching. In an encoding scenario other than CA-polar encoding, the first information is code length information that is of the to-be-transmitted data and that is obtained after rate matching.

For ease of description, the code length of the to-be-transmitted data is denoted as N bits below. The first information may indicate N.

The second information is length information of the information bit, and a length of the information bit is a bit length that needs to be transmitted and that is generated by the source at the transmit end, and may be denoted as K. The second information may indicate K.

Optionally, the first communication apparatus may determine the code length information and the length information of the information bit based on resource configuration information corresponding to the information bit. For example, the first communication apparatus may determine N and K based on time-frequency resource information such as a quantity of available resource elements (resource element, RE) in a physical resource block (physical resource block, PRB), a quantity of transport layers, and a code rate R and a modulation order Q in a modulation and coding scheme (modulation and coding scheme, MCS) table.

For example, if the first communication apparatus is a terminal device, the terminal device may receive (or obtain) the resource configuration information from a network device. The resource configuration information may be used to preconfigure a transmission parameter of the information bit. The transmission parameter may include the code length information of the to-be-transmitted data including the information bit and/or the length information of the information bit.

Alternatively, if the first communication apparatus is a network device, the network device may determine the first information and the second information based on the resource configuration information, and include the first information and the second information in the resource configuration information sent to a terminal device.

S402: The first communication apparatus determines, based on a first correspondence, that a check bit length is L, where L is a natural number.

In this application, the first correspondence includes a correspondence among the code length information of the to-be-transmitted data including the information bit, the length information of the information bit, and the check bit length.

The first correspondence may include a correspondence table among the code length information of the to-be-transmitted data including the information bit, the length information of the information bit, and the check bit length. Optionally, the correspondence table may further include a first CRC polynomial. As shown in FIG. 5 to FIG. 7, N represents the code length of the to-be-transmitted data including the information bit, K represents the length of the information bit, and L represents the check bit length. Optionally, for different first CRC polynomials, correspondences among N, K, and L in correspondence tables shown in FIG. 5 to FIG. 7 remain unchanged.

Optionally, FIG. 5 to FIG. 7 respectively include correspondence tables among N, K, and L when N=32, N=30, and N=40. In FIG. 5 to FIG. 7, a value range of K is 1 to 19.

Based on FIG. 5 to FIG. 7, different (N, K) combinations correspond to different values of L. Therefore, after determining the first information (or determining N) and the second information (or determining K), the first communication apparatus may determine, based on the correspondence table among the code length information of the to-be-transmitted data including the information bit, the length information of the information bit, and the check bit length, L that corresponds to N indicated by the first information and K indicated by the second information.

Optionally, in an example of determining the correspondence table, L may be determined based on a CRC polynomial (namely, a generator polynomial of the check bit) that enables optimal encoding performance in a case of a combination of N and K. For example, a highest power in the CRC polynomial that enables the optimal encoding performance is used as L corresponding to the combination of C and K in the correspondence table. In addition, the first correspondence may alternatively be set through manual configuration. This is not specifically limited in this application.

Optionally, the first communication apparatus may further obtain indication information (which may be referred to as first indication information) of the first correspondence. The indication information may be sent by an apparatus that transmits the information bit with the first communication apparatus. For example, if the first communication apparatus is a terminal device, the network device may send the indication information to the first communication apparatus. Correspondingly, the first communication apparatus may receive the indication information from the network device. The first correspondence may be determined by the network device, or may be determined through preconfiguration or predefinition. In addition, that the first communication apparatus obtains the indication information of the first correspondence may also be understood as that the first communication apparatus reads the indication information through a communication interface.

S403: The first communication apparatus determines a first check bit based on the first CRC polynomial, where a length of the first check bit is L, and the first check bit is a check bit of the information bit.

The highest power in the first CRC polynomial is Lmax, Lmax is a positive integer, and Lmax is greater than or equal to L. The first CRC polynomial may be a generator polynomial that is of the check bit and that is agreed on between the transmit end and the receive end of the information bit.

Alternatively, the first CRC polynomial may be determined through protocol definition, preconfiguration, predefinition, or the like. With reference to the descriptions in this application, a check bit (referred to as a second check bit) whose length is Lmax may be generated based on the first CRC polynomial.

Optionally, if L=0 is determined in S402, in S403, the first communication apparatus may generate, based on the first CRC polynomial, a first check bit whose length is 0.

Alternatively, when L=0, the first communication apparatus determines that the first check bit does not need to be generated. In other words, the first communication apparatus may skip performing S403, that is, does not perform a CRC check. For example, the first communication apparatus may perform subsequent processing on the information bit. For example, in CA-polar code encoding, the first communication apparatus may perform polar encoding on the information bit.

Based on a procedure shown in FIG. 4, the first communication apparatus may determine, based on the code length information of the to-be-transmitted data and the length information of the information bit, that a corresponding check bit length is L, and may further generate, based on the first CRC polynomial, a first check bit whose length is L. Therefore, the check bit length may be flexibly determined based on the code length and the bit length.

The following describes, by using an example, a manner in which the first communication apparatus generates the first check bit in S403.

Manner 1: The first communication apparatus determines a second check bit based on the first CRC polynomial, and then determines the first check bit based on the second check bit.

In Manner 1, the first communication apparatus may generate, based on the first CRC polynomial, the check bit whose length is Lmax, namely, the second check bit, and then determine L bits as the first check bit based on the second check bit. For a manner of determining the second check bit based on the first CRC polynomial, refer to a manner of generating the check bit based on the generator polynomial of the check bit described in this application. Details are not described again.

Optionally, a method for determining the L bits based on the second check bit may be: selecting L bits from the second check bit in a front-to-back order. A bit stream 0100 is used as an example. Selecting 2 bits in the front-to-back order means selecting 01. In addition, selecting 2 bits in a back-to-front order means selecting 00. In addition, the method for determining the L bits may also be: selecting L bits from the second check bit in a back-to-front order; or connecting two ends of the second check bit, and extracting L bits in a front-to-back order or a back-to-front order starting from a location in the middle; randomly extracting L bits, or the like. This is not specifically required.

The following describes Manner 1 with reference to a correspondence table shown in FIG. 5.

If the first CRC polynomial is D^11+D^10+D^9+D^5+1, a length of the second check bit determined based on the first CRC polynomial is 11 bits. When N=32 and K={1, 2}, in S402, the first communication apparatus may query the correspondence table shown in FIG. 5, and determine that L corresponding to the combination of N and K is 0, and the first communication apparatus may extract a 0-bit first check bit from an 11-bit second check bit generated based on the first CRC polynomial. K={1, 2} indicates that K=1 or K=2. When N=32 and K={3}, L corresponding to the combination of N and K shown in FIG. 5 is 1, and the first communication apparatus may extract a 1-bit first check bit from an 11-bit second check bit generated based on the first CRC polynomial, for example, select a 1st bit in the second check bit as the first check bit. When N=32 and K={4, 5, 6}, L corresponding to the combination of N and K shown in FIG. 5 is 2, and the first communication apparatus may extract a 2-bit first check bit from an 11-bit second check bit generated based on the first CRC polynomial, for example, select first 2 bits in the second check bit as the first check bit. When N=32 and K={7, 8, 9, 10, 11, 12, 13}, L corresponding to the combination of N and K shown in FIG. 5 is 4, and the first communication apparatus may extract a 4-bit first check bit from an 11-bit second check bit generated based on the first CRC polynomial, for example, select first 4 bits in the second check bit as the first check bit. When N=32 and K={14}, L corresponding to the combination of N and K shown in FIG. 5 is 5, and the first communication apparatus may extract a 5-bit first check bit from an 11-bit second check bit generated based on the first CRC polynomial, for example, select first 5 bits in the second check bit as the first check bit. When N=32 and K={15, 16, 17, 18, 19}, L corresponding to the combination of N and K shown in FIG. 5 is 6, and the first communication apparatus may extract a 6-bit first check bit from an 11-bit second check bit generated based on the first CRC polynomial, for example, select first 6 bits in the second check bit as the first check bit.

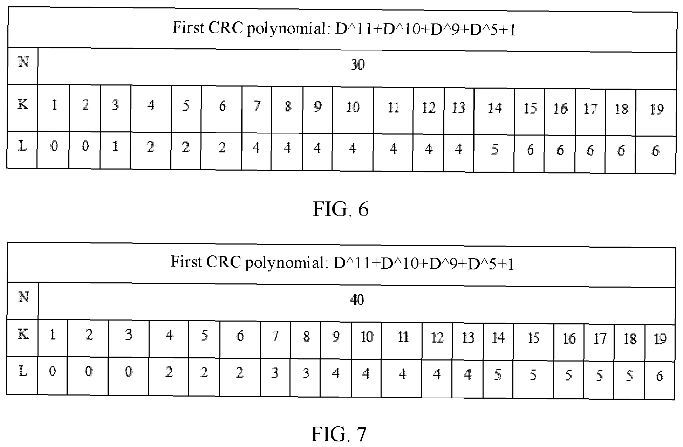

It may be understood that an implementation of Manner 1 described by using FIG. 5 as an example may also be implemented based on a correspondence table shown in FIG. 6 or FIG. 7, and an implementation is not described again. In addition, in the process of the foregoing examples, a time sequence in which the first communication apparatus determines the second check bit is not limited in this application. For example, the first communication apparatus may determine the second check bit based on the first CRC polynomial before determining, in S402, that the check bit length is L, and determine the first check bit based on the second check bit after determining, in S402, that the check bit length is L. For another example, after determining, in S402, that the check bit length is L, the first communication apparatus may generate the second check bit based on the first CRC, and then generate the first check bit based on the second check bit.

Manner 2: A second CRC polynomial is determined based on the first CRC polynomial, a highest power in the second CRC is L, and then the first check bit is determined based on the second CRC polynomial.

Manner 2 may further specifically include the following two optional implementations based on whether the first CRC polynomial includes a term whose highest power is L:

Manner 2-1: The first CRC polynomial includes a term whose power is L, and terms in the second CRC polynomial include a term whose power is not greater than L in the first CRC polynomial. Therefore, in Manner 2-1, the second CRC polynomial may include all terms whose powers are not greater than L in the first CRC polynomial.

In other words, in Manner 2-1, a set {Lₙ, Lₙ₋₁, ..., Lₙ₂, Lₙ₁, Lₙ₀} including exponents of terms in the second CRC polynomial g_{CRC_{L}} = D^{Lₙ}+D^{Lₙ₋₁}+...+D^{Lₙ₂}+D^{Lₙ₁}+D^{Lₙ₀} is a subset of a set {Lₘ, Lₘ₋₁, ..., Lₘ₂, Lₘ₁, Lₘ₀} including exponents of terms in the first CRC polynomial g_{CRC_{Lmax}}. Herein, Lₙ = L and Lₙ₀ =0.

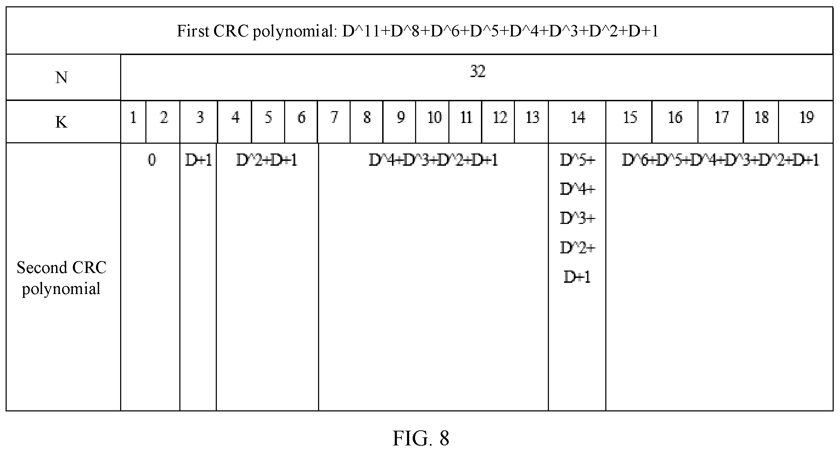

As shown in FIG. 8, if the first CRC polynomial is D^11+D^8+D^6+D^5+D^4+D^3+D^2+D+1, N=32, and the value range of K is 1 to 19, when N=32 and K={1, 2} (that is, L=0), the second CRC polynomial is 0; when N=32 and K={3} (that is, L=1), the second polynomial is: D+1; when N=32 and K={4, 5, 6} (that is, L=2), the second polynomial is D^2+D+1; when N=32 and K={7, 8, 9, 10, 11, 12, 13} (that is, L=4), the second CRC polynomial is D^4+D^3+D^2+D+1; when N=32 and K={14} (that is, L=5), the second CRC polynomial is D^5+D^4+D^3+D^2+D+1; and when N=32 and K={15, 16, 17, 18, 19} (that is, L=6), the second CRC polynomial is D^6+D^5+D^4+D^3+D^2+D+1.

Further, the first communication apparatus may determine the first check bit based on the second CRC polynomial. For a manner of determining the first check bit based on the second CRC polynomial, refer to a manner of generating the check bit based on the generator polynomial of the check bit described in this application. Details are not described again.

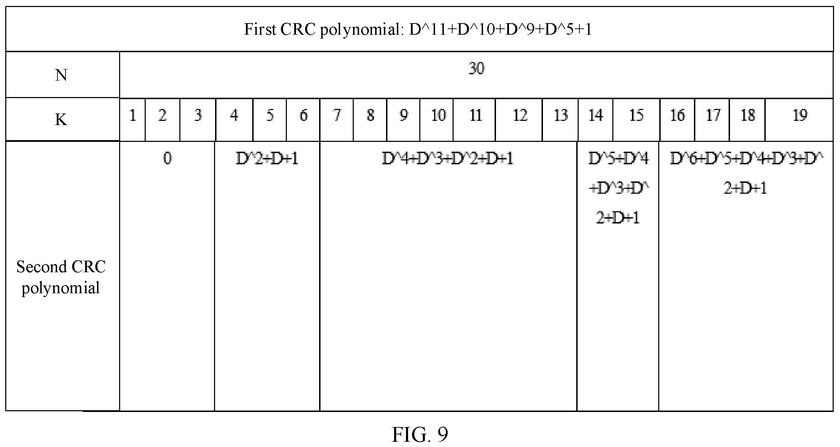

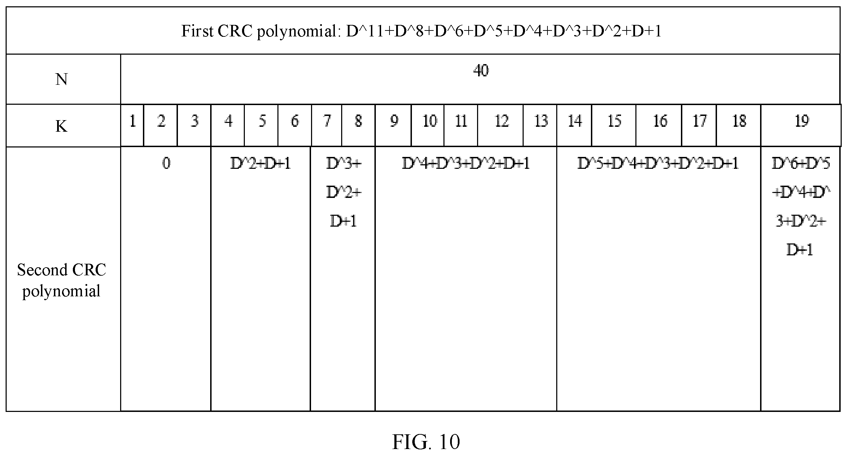

In addition, FIG. 9 shows a correspondence among the first CRC polynomial, N, K, and the second CRC polynomial when the first CRC polynomial is (D^11+D^10+D^9+D^5+1), N=30, and K=1, 2, ..., 19. FIG. 10 shows a correspondence among the first CRC polynomial, N, K, and the second CRC polynomial when the first CRC polynomial is (D^11+D^8+D^6+D^5+D^4+D^3+D^2+D+1), N=40, and K=1, 2, ..., 19.

Optionally, the first communication apparatus may store a correspondence (which may be referred to as a second correspondence below) among the first CRC polynomial, N, K, and the second CRC polynomial shown in FIG. 8, and/or the first communication apparatus may store a correspondence (which may be referred to as a third correspondence below) among the first CRC polynomial, L, and the second CRC polynomial. Therefore, in Manner 2-1, the first communication apparatus may determine the second CRC polynomial based on the second correspondence and/or the third correspondence, to quickly determine the second CRC polynomial. In addition, the first communication apparatus may alternatively determine the second CRC polynomial based on L and the first CRC polynomial after determining L. Therefore, the second correspondence and the third correspondence do not need to be stored in advance.

Optionally, the first communication apparatus may obtain (for example, receive) indication information of the second correspondence and/or the third correspondence. The indication information may be sent by the apparatus that transmits the information bit with the first communication apparatus. For example, if the first communication apparatus is a terminal device, the network device may send the indication information to the first communication apparatus. The second correspondence and/or the third correspondence may be determined by the network device, or may be determined through preconfiguration or predefinition.

Optionally, the first communication apparatus may obtain (for example, receive) the first indication information. The first indication information may indicate the first correspondence, and may indicate at least one of the second correspondence and the third correspondence.

For example, as shown in FIG. 8, in Manner 2-1, when the code length is N=32 and a quantity K of message bits is 1 or 2, L=0, and the second CRC polynomial is 0, that is, the length of the first check bit is 0; when N=32 and K=3, L=1, and the first communication apparatus may extract last two terms in the first CRC polynomial to obtain the second CRC polynomial (D+1), generate 1 check bit based on the second CRC polynomial, and use the 1 check bit as the first check bit; when N=32 and K={4, 5, 6}, L=2, and the first communication apparatus may extract last three terms in the first CRC polynomial to obtain the second CRC polynomial (D^2+D+1), generate 2 check bits based on the second CRC polynomial, and use the 2 check bits as the first check bit; when N=32 and K={7, 8, 9, 10, 11, 12, 13}, L=4, and the first communication apparatus may obtain the second CRC polynomial (D^4+D^3+D^2+D+1) based on last five terms in the first CRC polynomial, generate 4 check bits based on the second CRC polynomial, and use the 4 check bits as the first check bit; when N=32 and K=14, L=5, and the first communication apparatus may obtain the second CRC polynomial (D^5+D^4+D^3+D^2+D+1) based on last six terms in the first CRC polynomial, generate 5 check bits based on the second CRC polynomial, and use the 5 check bits as the first check bit; and when N=32 and K={15, 16, 17, 18, 19}, L=6, and the first communication apparatus may obtain the second CRC polynomial (D^6+D^5+D^4+D^3+D^2+D+1) based on last seven terms in the first CRC polynomial, generate 6 check bits based on the second CRC polynomial, and use the 6 check bits as the first check bit.

Manner 2-2: The second CRC polynomial includes at least one term in the first CRC polynomial, and further includes a term outside the first CRC polynomial. In other words, the second CRC polynomial is obtained by supplementing a new term to the at least one term in the first CRC polynomial.

For example, the first CRC polynomial does not include a term whose power is L, and the terms in the second CRC polynomial are a term whose power includes L and at least one term whose power is less than L in the first CRC polynomial (or at least one term whose power is less than L in the first CRC polynomial). Therefore, in Manner 2-2, in addition to obtaining the second CRC polynomial based on the term whose power is less than L in the first CRC polynomial, the term whose power is L needs to be additionally supplemented as at least one term in the second CRC polynomial, so that a highest power of the terms in the second CRC polynomial is L.

Optionally, the second CRC polynomial may be alternatively obtained by supplementing, based on some or all terms in the first CRC polynomial, at least one term whose power is less than L. For example, the second CRC polynomial may further include a term whose power is less than L and does not belong to the first CRC polynomial. For example, if the first CRC polynomial does not include a term whose power is (L-1), in addition to the term whose power is less than L in the first CRC polynomial, the second CRC polynomial may further include a term whose power is (L-1).

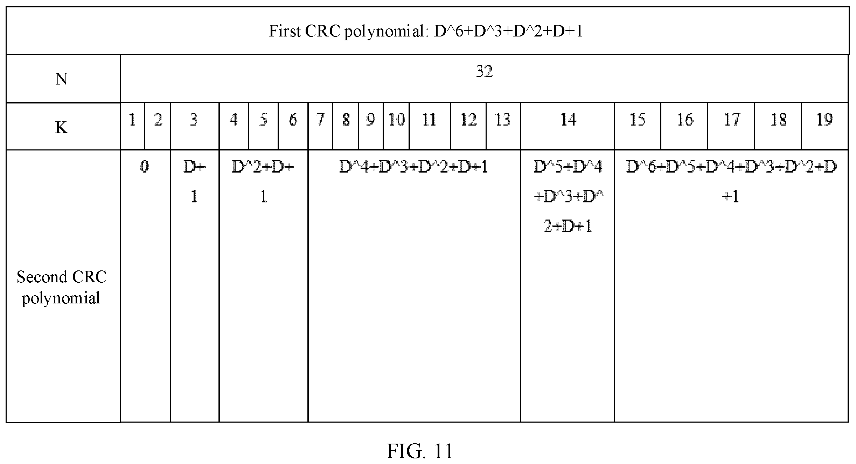

As shown in FIG. 11, if the first CRC polynomial is D^6+D^3+D^2+D+1, N=32, and the value range of K is 1 to 19, when N=32 and K={7, 8, 9, 10, 11, 12, 13} (that is, L=4), the second CRC polynomial is D^4+D^3+D^2+D+1, where D^4 is not a term in the first CRC polynomial; when N=32 and K={14} (that is, L=5), the second CRC polynomial is D^5+D^4+D^3+D^2+D+1, where D^5 and D^4 are not terms in the first CRC polynomial; and when N=32 and K={15, 16, 17, 18, 19} (that is, L=6), the second CRC polynomial is D^6+D^5+D^4+D^3+D^2+D+1, where D^5 and D^4 are not terms in the first CRC polynomial.

Further, in Manner 2-2, the first communication apparatus may determine the first check bit based on the second CRC polynomial. For a manner of determining the first check bit based on the second CRC polynomial, refer to a manner of generating the check bit based on the generator polynomial of the check bit described in this application. Details are not described again.

Optionally, the first communication apparatus may store a correspondence (which may be referred to as a fourth correspondence below) among the first CRC polynomial, N, K, and the second CRC polynomial shown in FIG. 11, and/or the first communication apparatus may store a correspondence (which may be referred to as a fifth correspondence below) among the first CRC polynomial, L, and the second CRC polynomial. Therefore, in Manner 2-2, the first communication apparatus may determine the second CRC polynomial based on the fourth correspondence and/or the fifth correspondence, to quickly determine the second CRC polynomial. In addition, the first communication apparatus may alternatively determine the second CRC polynomial based on L and the first CRC polynomial after determining L. Therefore, the fourth correspondence and the fifth correspondence do not need to be stored in advance.

It may be understood that, in this application, a difference between the second correspondence and the fourth correspondence lies in that, in the second correspondence, all terms in the second CRC polynomial are included in the first CRC polynomial, and in the fourth correspondence, the terms in the second CRC polynomial include at least one term that does not belong to the first CRC polynomial. Similarly, in the fifth correspondence, the terms in the second CRC polynomial include at least one term that does not belong to the first CRC polynomial.

Optionally, the first communication apparatus may obtain (for example, receive) indication information of the fourth correspondence and/or the fifth correspondence. The indication information may be sent by the apparatus that transmits the information bit with the first communication apparatus. For example, if the first communication apparatus is a terminal device, the network device may send the indication information to the first communication apparatus. The fourth correspondence and/or the fifth correspondence may be determined by the network device, or may be determined through preconfiguration or predefinition.

Optionally, the first communication apparatus may obtain (for example, receive) the first indication information. The first indication information may indicate the first correspondence, and may indicate at least one of the fourth correspondence and the fifth correspondence. For example, the first communication apparatus may receive the first indication information from the network device.

Optionally, in Manner 2, the first communication apparatus may further determine whether the second CRC polynomial is a reducible polynomial.

If a rational coefficient polynomial whose power is greater than zero can be factorized into a product of two rational coefficient polynomials whose powers are small but both are greater than zero, the polynomial is referred to as a reducible polynomial.

If the second CRC polynomial obtained in Manner 2-1 or Manner 2-2 is a reducible polynomial, that is, the second CRC polynomial may be factorized into a product of two rational coefficient polynomials whose powers are lower but both are greater than zero, the first communication apparatus may further determine a third CRC polynomial based on the second CRC polynomial. The third CRC polynomial is not a reducible polynomial, that is, the third CRC polynomial cannot be factorized into a product of two rational coefficient polynomials whose powers are lower but both are greater than zero.

Optionally, the first communication apparatus may delete at least one term other than the term whose power is L in the terms included in the second CRC polynomial, that is, delete at least one term whose power is less than L from the second CRC polynomial, to obtain the irreducible third CRC polynomial. When a CRC polynomial is a reducible polynomial, an error correction capability corresponding to a check bit generated based on the polynomial is reduced. Therefore, the check bit may be generated based on the third CRC polynomial, to improve the error correction capability.

It may be understood that Manner 1, Manner 2-1, and Manner 2-2 indicate example descriptions of the manner of determining the first check bit based on the first CRC polynomial in this application, and the foregoing manners may be further implemented in combination. For example, for a same first CRC polynomial and N, the first check bit is determined in at least two different manners in Manner 1, Manner 2-1, and Manner 2-2 in a case of different value ranges of K. For another example, for different first CRC polynomials, the first check bit may be determined in different manners in Manner 1, Manner 2-1, and Manner 2-2. Details are not described again.

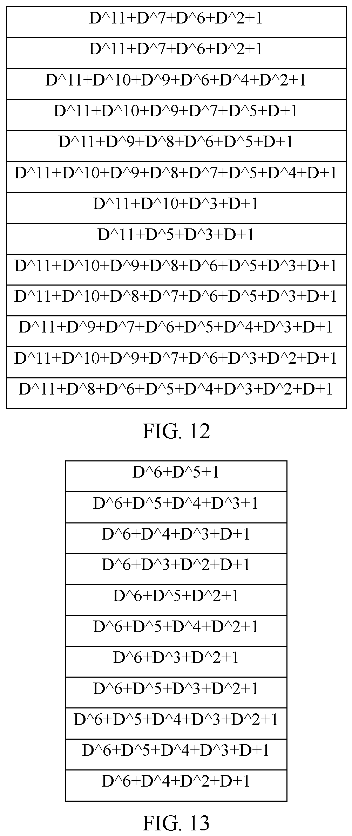

Optionally, in this application, in addition to the polynomial in the foregoing example, the first CRC polynomial may be further any CRC polynomial shown in FIG. 12 or FIG. 13. A highest power of polynomials shown in FIG. 12 is 11, and a highest power of polynomials shown in FIG. 13 is 6.

Optionally, the first communication apparatus in this application may further send second indication information to a second communication apparatus after determining, in S402, that the check bit length is L. The second indication information may indicate that the check bit length is L. Therefore, the first communication apparatus and the second communication apparatus use check bits of a same degree. Optionally, the second communication apparatus may determine, in which the first communication apparatus determines the first check bit in S403, the check bit whose length is L in the manner. An implementation is not described again.

Based on a same concept, an embodiment of this application further provides a communication method. The method may be implemented by a first device and a second device. The first device and the second device each may serve as either a transmit end or a receive end of a to-be-sent information bit. For example, the first device may serve as the transmit end or included in the transmit end, and the second device may serve as the receive end or included in the receive end; or the first device may serve as the receive end or included in the receive end, and the second device may serve as the transmit end or included in the transmit end. In the method, the first device may determine the check bit length L in the method shown in FIG. 4, and the first device sends second indication information to the second device. The second indication information may indicate that the check bit length is L. Correspondingly, the second device may learn of L, and further determine a first check bit. Therefore, in the method, the transmit end or the receive end may determine a length of the first check bit, and indicate the length to a peer end, to reduce processing complexity of the peer end.

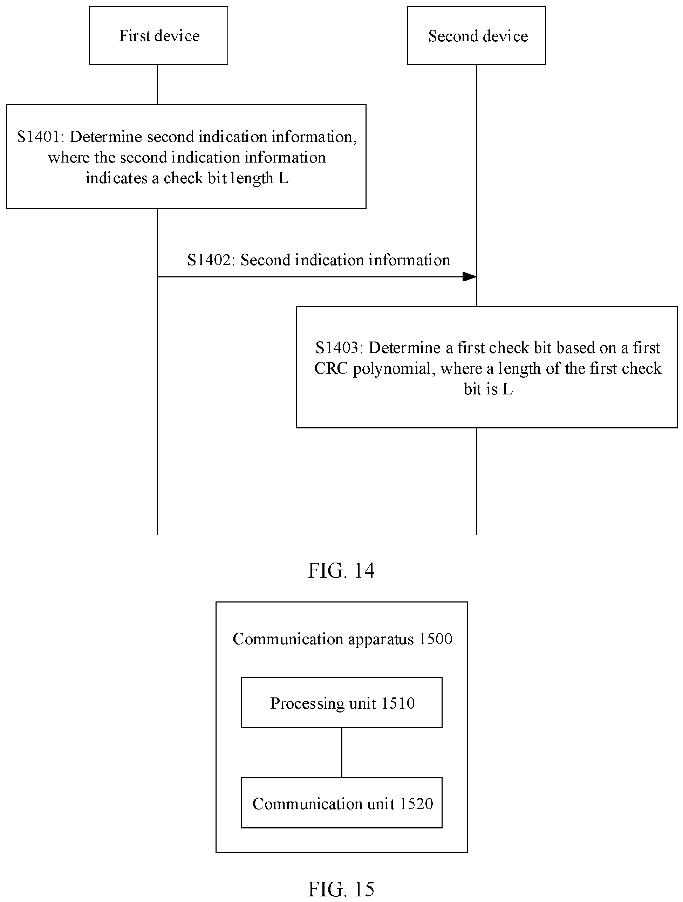

As shown in FIG. 14, a communication method provided in an embodiment of this application may include the following steps.

S1401: A first device determines second indication information, where the second indication information indicates a check bit length L.

For a manner of determining the check bit length L, refer to the descriptions of S401 and S402. Details are not described herein again.

For example, in the descriptions in S401, the first device may determine, based on resource configuration information corresponding to an information bit, code length information N of to-be-transmitted data including a check bit and a length K of the information bit, and determine, based on a first correspondence, that the check bit length is L. The first correspondence may include a correspondence among N, K, and L.

For example, the second indication information may include a check bit length indication field or an information element. For example, a value of the field or the information element may be set to L.

Optionally, as described above, the first device may obtain first indication information. The first indication information may indicate the first correspondence. In addition, the first correspondence may also be preconfigured, predefined, or defined in a protocol.

S1402: The first device sends the second indication information to the second device.

Correspondingly, the second device may obtain the second indication information, and determine, based on the second device, that the check bit length is L.

Optionally, the second indication information may be carried on a control channel or a data channel. This is not specifically limited in this application.

S1403: The second device determines a first check bit based on a first CRC polynomial, where a length of the first check bit is L.

For a manner in which the second device determines the first check bit based on the first CRC polynomial, refer to the description of the manner in which the first device determines the first check bit based on the first CRC polynomial in S403. Details are not described herein again. For example, the second device may determine the first check bit in Manner 1 or Manner 2.

It may be understood that, to implement functions in the foregoing embodiments, an embodiment of this application further provides a communication apparatus. The communication apparatus may include a corresponding hardware structure and/or software module for performing each function. Persons skilled in the art should be easily aware that, in this application, the units and method steps in the examples described with reference to embodiments disclosed in this application can be implemented by hardware or a combination of hardware and computer software. Whether a function is performed by hardware or hardware driven by computer software depends on particular application scenarios and design constraint conditions of the technical solutions.

FIG. 15 to FIG. 17 each are a diagram of a structure of a possible communication apparatus according to an embodiment of this application. The communication apparatus may be configured to implement a function of the first communication apparatus in the foregoing method embodiments. Therefore, beneficial effects of the foregoing method embodiments can also be achieved. In a possible implementation, the communication apparatus may be the network device or the terminal device shown in FIG. 1. For related details and effects, refer to the descriptions in the foregoing embodiments.

As shown in FIG. 15, the communication apparatus 1500 includes a processing unit 1510 and a communication unit 1520. The communication unit 1520 may alternatively be a transceiver unit, an input/output interface, or the like. The communication apparatus 1500 may be configured to implement functions of the first communication apparatus in the method embodiments shown in FIG. 4 and/or FIG. 14.

Optionally, when the method performed by the first communication apparatus shown in FIG. 4 is implemented, the communication unit 1520 may be configured to obtain an information bit. The processing unit 1510 may be configured to: determine, based on a first correspondence, that a check bit length is L, where L is a natural number, and the first correspondence includes a correspondence among code length information of to-be-transmitted data including the information bit, length information of the information bit, and the check bit length; and determine a first check bit based on a first CRC polynomial, where a highest power of terms in the first CRC polynomial is Lmax, Lmax is a positive integer, Lmax is greater than or equal to L, and a length of the first check bit is L.

Optionally, the processing unit 1510 may be specifically configured to: determine a second check bit based on the first CRC polynomial, where a length of the second check bit is Lmax; and determine the first check bit based on the second check bit.

Optionally, the processing unit 1510 may be specifically configured to: determine a second CRC polynomial based on the first CRC polynomial, where a highest power of the second CRC is L; and determine the first check bit based on the second CRC polynomial.

Optionally, the processing unit 1510 may be specifically configured to: delete at least one term other than the term whose power is L from the second CRC polynomial, to obtain a third CRC polynomial, where the second CRC polynomial is a reducible polynomial, and the third CRC polynomial is not a reducible polynomial; and determine the first check bit based on the third CRC polynomial.

Optionally, the processing unit 1510 may be further configured to obtain first indication information. The first indication information indicates the first correspondence.

Optionally, the processing unit 1510 may be further configured to send second indication information. The second indication information indicates that the check bit length is L.

When an action performed by a first device in the method shown in FIG. 14 is implemented, the processing unit 1510 may be configured to determine second indication information. The communication unit 1520 may be configured to send the second indication information. For the second indication information, refer to descriptions of content shown in FIG. 14. Details are not described herein again.

Optionally, the processing unit 1510 may be further configured to: determine a second check bit based on the first CRC polynomial, where a length of the second check bit is Lmax; and determine the first check bit based on the second check bit.

Optionally, the processing unit 1510 may be specifically configured to: determine a second CRC polynomial based on the first CRC polynomial, where a highest power of the second CRC is L; and determine the first check bit based on the second CRC polynomial.

Optionally, the processing unit 1510 may be specifically configured to: delete at least one term other than the term whose power is L from the second CRC polynomial, to obtain a third CRC polynomial, where the second CRC polynomial is a reducible polynomial, and the third CRC polynomial is not a reducible polynomial; and determine the first check bit based on the third CRC polynomial.

Optionally, the processing unit 1510 may be further configured to obtain first indication information. The first indication information indicates the first correspondence.

When an action performed by a second device in the method shown in FIG. 14 is implemented, the communication unit 1520 may be configured to obtain second indication information. The processing unit 1510 may be configured to: determine a second check bit based on the first CRC polynomial, where a length of the second check bit is Lmax; and determine the first check bit based on the second check bit.

Optionally, the processing unit 1510 may be further configured to: determine a second CRC polynomial based on the first CRC polynomial, where a highest power of the second CRC is L; and determine the first check bit based on the second CRC polynomial.

Optionally, the processing unit 1510 may be specifically configured to: delete at least one term other than the term whose power is L from the second CRC polynomial, to obtain a third CRC polynomial, where the second CRC polynomial is a reducible polynomial, and the third CRC polynomial is not a reducible polynomial; and determine the first check bit based on the third CRC polynomial.

Division into the modules in embodiments of this application is an example, is merely division into logical functions, and may be other division during actual implementation. In addition, functional modules in embodiments of this application may be integrated into one processor, or each of the modules may exist alone physically, or two or more modules may be integrated into one module. The integrated module may be implemented in a form of hardware, or may be implemented in a form of a software functional module.

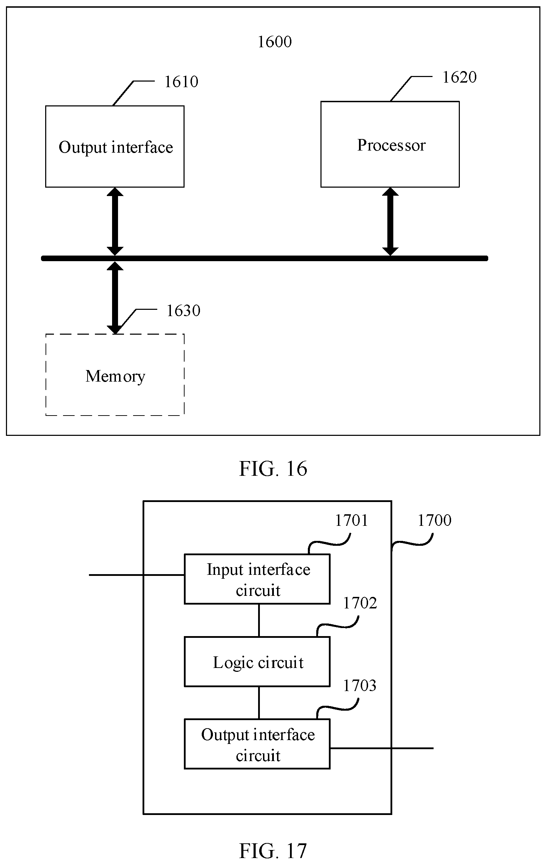

FIG. 16 shows a communication apparatus 1600 according to an embodiment of this application. The communication apparatus 1600 is configured to implement the communication method provided in this application. The communication apparatus 1600 may be a communication apparatus to which the communication method is applied, or may be a component in the communication apparatus, or may be an apparatus that can be used in combination with the communication apparatus. The communication apparatus 1600 may be a first communication apparatus. The communication apparatus 1600 may be a chip system or a chip. In this embodiment of this application, the chip system may include a chip, or may include a chip and another discrete component. The communication apparatus 1600 includes at least one processor 1620, configured to implement the communication method provided in embodiments of this application. The communication apparatus 1600 may further include an output interface 1610, and the output interface may also be referred to as an input/output interface. In this embodiment of this application, the output interface 1610 may be configured to communicate with another apparatus by using a transmission medium, and a function of the output interface 1610 may include sending and/or receiving. For example, when the communication apparatus 1600 is a chip, the communication apparatus 1600 performs transmission with another chip or component through the output interface 1610. The processor 1620 may be configured to implement the method described in the foregoing method embodiments.

For example, the processor 1620 may be configured to perform an action performed by the processing unit 1510, and the output interface 1610 may be configured to perform an action performed by the communication unit 1520. Details are not described again.

Optionally, the communication apparatus 1600 may further include at least one memory 1630, configured to store program instructions and/or data. The memory 1630 is coupled to the processor 1620. The coupling in this embodiment of this application may be an indirect coupling or a communication connection between apparatuses, units, or modules in an electrical form, a mechanical form, or another form, and is used for information exchange between the apparatuses, the units, or the modules. The processor 1620 may cooperate with the memory 1630. The processor 1620 may execute the program instructions stored in the memory 1630. At least one of the at least one memory may be integrated with the processor.

In this embodiment of this application, the memory 1630 may be a non-volatile memory, such as a hard disk drive (hard disk drive, HDD) or a solid-state drive (solid-state drive, SSD), or may be a volatile memory (volatile memory), such as a random access memory (random-access memory, RAM). The memory is any other medium that can carry or store expected program code in a form of an instruction or a data structure and that can be accessed by a computer, but is not limited thereto. The memory in this embodiment of this application may alternatively be a circuit or any other apparatus that can implement a storage function, and is configured to store the program instructions and/or the data.

In this embodiment of this application, the processor 1620 may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in this embodiment of this application. The general-purpose processor may be a microprocessor, any conventional processor, or the like. The steps of the method disclosed with reference to embodiments of this application may be directly performed by a hardware processor, or may be performed by using a combination of hardware in the processor and a software module.

FIG. 17 shows a communication apparatus 1700 according to an embodiment of this application. The communication apparatus 1700 is configured to implement the communication method provided in this application. The communication apparatus 1700 may be a communication apparatus to which the communication method shown in embodiments of this application is applied, or may be a component in the communication apparatus, or may be an apparatus that can be used in combination with the communication apparatus. The communication apparatus 1700 may be a first communication apparatus. The communication apparatus 1700 may be a chip system or a chip. In this embodiment of this application, the chip system may include a chip, or may include a chip and another discrete component. Some or all of the communication methods in which a Huygens equivalent surface is applied provided in the foregoing embodiments may be implemented by hardware or may be implemented by software. When the communication method is implemented by hardware, the communication apparatus 1700 may include an input interface circuit 1701, a logic circuit 1702, and an output interface circuit 1703.

Optionally, for example, the apparatus is configured to implement a function of a receive end. The input interface circuit 1701 may be configured to perform the receiving action performed by the communication unit 1520, the output interface circuit 1703 may be configured to perform the sending action performed by the communication unit 1520, and the logic circuit 1702 may be configured to perform the action performed by the processing unit 1510. Details are not described again.

Optionally, in a specific implementation, the communication apparatus 1700 may be a chip or an integrated circuit.

Some or all of operations and functions performed by the data transmission apparatus described in the foregoing method embodiments of this application may be implemented by using the chip or the integrated circuit.

An embodiment of this application provides a computer-readable storage medium storing a computer program. The computer program includes instructions for performing the foregoing method embodiments.

An embodiment of this application provides a computer program product including instructions. When the computer program product is run on a computer, the computer is enabled to perform the foregoing method embodiments.

An embodiment of this application provides a communication system. Specifically, the communication system may include a first communication apparatus configured to implement the method shown in FIG. 4 and/or FIG. 14. For details, refer to the related descriptions in the foregoing method embodiments. Details are not described herein again. The communication system may include the structure shown in FIG. 1 or FIG. 2.

Persons skilled in the art should understand that embodiments of this application may be provided as a method, a system, or a computer program product. Therefore, this application may be in a form of hardware only embodiments, software only embodiments, or embodiments with a combination of software and hardware. In addition, this application may be in a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to embodiments of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer-readable memory that can instruct the computer or any other programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams.

The computer program instructions may alternatively be loaded onto a computer or another programmable data processing device, so that a series of operations and steps are performed on the computer or the another programmable device, so that computer-implemented processing is generated. Therefore, the instructions executed on the computer or the another programmable device provide steps for implementing a specific function in one or more procedures in the flowcharts and/or in one or more blocks in the block diagrams.

Although preferred embodiments of this application are described, persons skilled in the art can make changes and modifications to these embodiments after they learn of a basic inventive concept. Therefore, the following claims are intended to be construed as to cover the preferred embodiments and all changes and modifications falling within the scope of this application.

It is clear that, persons skilled in the art may make various modifications and variations to embodiments of this application without departing from the scope of embodiments of this application. In this case, this application is intended to cover these modifications and variations of embodiments of this application provided that they fall within the scope of protection defined by the following claims and their equivalent technologies.

## Claims

1. A cyclic redundancy check bit determining method, comprising:
obtaining an information bit;
determining, based on a first correspondence, that a check bit length is L, wherein L is a natural number, and the first correspondence comprises a correspondence among code length information of to-be-transmitted data comprising the information bit, length information of the information bit, and the check bit length; and
determining a first check bit based on a first cyclic redundancy check CRC polynomial, wherein a length of the first check bit is the check bit length L, a highest power of terms in the first CRC polynomial is Lmax, Lmax is a positive integer, and Lmax is greater than or equal to L.

2. The method according to claim 1, wherein the determining a first check bit based on a first cyclic redundancy check CRC polynomial comprises:
determining a second check bit based on the first CRC polynomial, wherein a length of the second check bit is Lmax; and
determining the first check bit based on the second check bit.

3. The method according to claim 1, wherein the determining a first check bit based on a first cyclic redundancy check CRC polynomial comprises:
determining a second CRC polynomial based on the first CRC polynomial, wherein a highest power of the second CRC is L; and
determining the first check bit based on the second CRC polynomial.

4. The method according to claim 3, wherein the first CRC polynomial comprises a term whose power is L, and terms in the second CRC polynomial comprise a term whose power is not greater than L in the first CRC polynomial.

5. The method according to claim 3, wherein the first CRC polynomial does not comprise a term whose power is L, and terms in the second CRC polynomial comprise a term whose power is L and at least one term whose power is less than L in the first CRC polynomial.

6. The method according to any one of claims 3 to 5, wherein the determining the first check bit based on the second CRC polynomial comprises:
deleting at least one term other than the term whose power is L from the second CRC polynomial, to obtain a third CRC polynomial, wherein the second CRC polynomial is a reducible polynomial, and the third CRC polynomial is not a reducible polynomial; and
determining the first check bit based on the third CRC polynomial.

7. The method according to any one of claims 1 to 6, wherein the method further comprises:
obtaining first indication information, wherein the first indication information indicates the first correspondence.

8. The method according to any one of claims 1 to 7, wherein the method further comprises:
sending second indication information, wherein the second indication information indicates that the check bit length is L.

9. A communication method, comprising:
determining, by a first device, second indication information, wherein the second indication information indicates a check bit length L, L is a natural number, L is determined based on a first correspondence, and the first correspondence comprises a correspondence among code length information of to-be-transmitted data comprising an information bit, length information of the information bit, and the check bit length; and
sending, by the first device, the second indication information to a second device.

10. The method according to claim 9, wherein the method further comprises:
determining, by the first device, a first check bit based on a first cyclic redundancy check CRC polynomial, wherein a length of the first check bit is L, a highest power of terms in the first CRC polynomial is Lmax, Lmax is a positive integer, and Lmax is greater than or equal to L.

11. The method according to claim 10, wherein the determining, by the first device, a first check bit based on a first cyclic redundancy check CRC polynomial comprises:
determining, by the first device, a second check bit based on the first CRC polynomial, wherein a length of the second check bit is Lmax; and
determining, by the first device, the first check bit based on the second check bit.

12. The method according to claim 10, wherein the determining, by the first device, a first check bit based on a first cyclic redundancy check CRC polynomial comprises:
determining, by the first device, a second CRC polynomial based on the first CRC polynomial, wherein a highest power of the second CRC is L; and
determining, by the first device, the first check bit based on the second CRC polynomial.

13. The method according to claim 12, wherein the first CRC polynomial comprises a term whose power is L, and terms in the second CRC polynomial comprise a term whose power is not greater than L in the first CRC polynomial.

14. The method according to claim 12, wherein the first CRC polynomial does not comprise a term whose power is L, and terms in the second CRC polynomial comprise a term whose power is L and at least one term whose power is less than L in the first CRC polynomial.

15. The method according to any one of claims 12 to 14, wherein the determining, by the first device, the first check bit based on the second CRC polynomial comprises:
deleting, by the first device, at least one term other than the term whose power is L from the second CRC polynomial, to obtain a third CRC polynomial, wherein the second CRC polynomial is a reducible polynomial, and the third CRC polynomial is not a reducible polynomial; and determining the first check bit based on the third CRC polynomial.

16. The method according to any one of claims 9 to 15, wherein the method further comprises:
obtaining, by the first device, first indication information, wherein the first indication information indicates the first correspondence.

17. A communication method, comprising:
obtaining, by a second device, first indication information, wherein second indication information indicates a check bit length L, and L is a natural number; and
determining, by the second device, a first check bit based on a first cyclic redundancy check CRC polynomial, wherein a length of the first check bit is L, a highest power of terms in the first CRC polynomial is Lmax, Lmax is a positive integer, and Lmax is greater than or equal to L.

18. The method according to claim 17, wherein the method further comprises:
determining, by the second device, a first check bit based on a first cyclic redundancy check CRC polynomial, wherein a length of the first check bit is L, a highest power of terms in the first CRC polynomial is Lmax, Lmax is a positive integer, and Lmax is greater than or equal to L.

19. The method according to claim 18, wherein the determining, by the second device, a first check bit based on a first cyclic redundancy check CRC polynomial comprises:
determining, by the second device, a second check bit based on the first CRC polynomial, wherein a length of the second check bit is Lmax; and
determining, by the first device, the first check bit based on the second check bit.

20. The method according to claim 18, wherein the determining, by the second device, a first check bit based on a first cyclic redundancy check CRC polynomial comprises:
determining, by the second device, a second CRC polynomial based on the first CRC polynomial, wherein a highest power of the second CRC is L; and
determining, by the second device, the first check bit based on the second CRC polynomial.

21. The method according to claim 20, wherein the first CRC polynomial comprises a term whose power is L, and terms in the second CRC polynomial comprise a term whose power is not greater than L in the first CRC polynomial.

22. The method according to claim 20, wherein the first CRC polynomial does not comprise a term whose power is L, and terms in the second CRC polynomial comprise a term whose power is L and at least one term whose power is less than L in the first CRC polynomial.

23. The method according to any one of claims 20 to 22, wherein the determining, by the second device, the first check bit based on the second CRC polynomial comprises:
deleting, by the second device, at least one term other than the term whose power is L from the second CRC polynomial, to obtain a third CRC polynomial, wherein the second CRC polynomial is a reducible polynomial, and the third CRC polynomial is not a reducible polynomial; and
determining the first check bit based on the third CRC polynomial.

24. A cyclic redundancy check bit determining apparatus, comprising a communication module and a processing module, wherein
the communication module is configured to obtain an information bit; and
the processing module is configured to: determine, based on a first correspondence, that a check bit length is L, wherein L is a natural number, and the first correspondence comprises a correspondence among code length information of to-be-transmitted data comprising the information bit, length information of the information bit, and the check bit length; and determine a first check bit based on a first cyclic redundancy check CRC polynomial, wherein a length of the first check bit is the check bit length L, a highest power of terms in the first CRC polynomial is Lmax, Lmax is a positive integer, and Lmax is greater than or equal to L.

25. The apparatus according to claim 24, wherein the processing module is specifically configured to:
determine a second check bit based on the first CRC polynomial, wherein a length of the second check bit is Lmax; and
determine the first check bit based on the second check bit.

26. The apparatus according to claim 24, wherein the processing module is specifically configured to:
determine a second CRC polynomial based on the first CRC polynomial, wherein a highest power of the second CRC is L; and
determine the first check bit based on the second CRC polynomial.

27. The apparatus according to claim 26, wherein the first CRC polynomial comprises a term whose power is L, and terms in the second CRC polynomial comprise a term whose power is not greater than L in the first CRC polynomial.

28. The apparatus according to claim 26, wherein the first CRC polynomial does not comprise a term whose power is L, and terms in the second CRC polynomial comprise a term whose power is L and at least one term whose power is less than L in the first CRC polynomial.

29. The apparatus according to any one of claims 26 to 28, wherein the processing module is specifically configured to:
delete at least one term other than the term whose power is L from the second CRC polynomial, to obtain a third CRC polynomial, wherein the second CRC polynomial is a reducible polynomial, and the third CRC polynomial is not a reducible polynomial; and determine the first check bit based on the third CRC polynomial.

30. The apparatus according to any one of claims 24 to 29, wherein the communication module is further configured to:
obtain first indication information from a network device, wherein the first indication information indicates the first correspondence.

31. The apparatus according to any one of claims 24 to 30, wherein the communication module is further configured to:
send second indication information to a second communication apparatus, wherein the second indication information indicates that the check bit length is L.

32. A first communication apparatus, comprising a communication module and a processing module, wherein
the processing module is configured to determine second indication information, wherein the second indication information indicates a check bit length L, L is a natural number, L is determined based on a first correspondence, and the first correspondence comprises a correspondence among code length information of to-be-transmitted data comprising an information bit, length information of the information bit, and the check bit length; and
the communication module is configured to send the second indication information to a second device.

33. The apparatus according to claim 32, wherein the processing module is further configured to:
determine a first check bit based on a first cyclic redundancy check CRC polynomial, wherein a length of the first check bit is L, a highest power of terms in the first CRC polynomial is Lmax, Lmax is a positive integer, and Lmax is greater than or equal to L.

34. The apparatus according to claim 33, wherein the processing module is specifically configured to:
determine a second check bit based on the first CRC polynomial, wherein a length of the second check bit is Lmax; and
determine the first check bit based on the second check bit.

35. The apparatus according to claim 33, wherein the processing module is specifically configured to:
determine a second CRC polynomial based on the first CRC polynomial, wherein a highest power of the second CRC is L; and
determine the first check bit based on the second CRC polynomial.

36. The apparatus according to claim 35, wherein the first CRC polynomial comprises a term whose power is L, and terms in the second CRC polynomial comprise a term whose power is not greater than L in the first CRC polynomial.

37. The apparatus according to claim 35, wherein the first CRC polynomial does not comprise a term whose power is L, and terms in the second CRC polynomial comprise a term whose power is L and at least one term whose power is less than L in the first CRC polynomial.

38. The apparatus according to any one of claims 35 to 37, wherein the processing module is specifically configured to:
delete at least one term other than the term whose power is L from the second CRC polynomial, to obtain a third CRC polynomial, wherein the second CRC polynomial is a reducible polynomial, and the third CRC polynomial is not a reducible polynomial; and determine the first check bit based on the third CRC polynomial.

39. The apparatus according to any one of claims 32 to 38, wherein the communication module is further configured to:
obtain first indication information, wherein the first indication information indicates the first correspondence.

40. A second communication apparatus, comprising a communication module and a processing module, wherein
the communication module is configured to obtain first indication information, wherein second indication information indicates a check bit length L; and
the processing module is configured to determine a first check bit based on a first cyclic redundancy check CRC polynomial, wherein a length of the first check bit is L, a highest power of terms in the first CRC polynomial is Lmax, Lmax is a positive integer, and Lmax is greater than or equal to L.

41. The apparatus according to claim 40, wherein the processing module is further configured to:
determine a first check bit based on a first cyclic redundancy check CRC polynomial, wherein a length of the first check bit is L, a highest power of terms in the first CRC polynomial is Lmax, Lmax is a positive integer, and Lmax is greater than or equal to L.

42. The apparatus according to claim 41, wherein the processing module is specifically configured to:
determine a second check bit based on the first CRC polynomial, wherein a length of the second check bit is Lmax; and
determine the first check bit based on the second check bit.

43. The apparatus according to claim 41, wherein the processing module is specifically configured to:
determine, by the second device, a second CRC polynomial based on the first CRC polynomial, wherein a highest power of the second CRC is L; and
determine, by the first device, the first check bit based on the second CRC polynomial.

44. The apparatus according to claim 43, wherein the first CRC polynomial comprises a term whose power is L, and terms in the second CRC polynomial comprise a term whose power is not greater than L in the first CRC polynomial.

45. The apparatus according to claim 43, wherein the first CRC polynomial does not comprise a term whose power is L, and terms in the second CRC polynomial comprise a term whose power is L and at least one term whose power is less than L in the first CRC polynomial.

46. The apparatus according to any one of claims 43 to 45, wherein the processing module is specifically configured to:
delete, by the second device, at least one term other than the term whose power is L from the second CRC polynomial, to obtain a third CRC polynomial, wherein the second CRC polynomial is a reducible polynomial, and the third CRC polynomial is not a reducible polynomial; and determining the first check bit based on the third CRC polynomial.

47. A communication apparatus, comprising a processor and an interface circuit, wherein the interface circuit is configured to: receive a signal from a communication apparatus other than the communication apparatus and transmit the signal to the processor, or send a signal from the processor to a communication apparatus other than the communication apparatus; and the processor is configured to implement, by using a logic circuit or by executing code instructions, the method according to any one of claims 1 to 8, the method according to any one of claims 9 to 16, or the method according to any one of claims 17 to 23.

48. A communication apparatus, comprising a processor and a memory, wherein the memory is configured to store one or more computer programs, the one or more computer programs comprise computer-executable instructions, and when the communication apparatus runs, the processor executes the one or more computer programs stored in the memory, to enable the communication apparatus to perform the method according to any one of claims 1 to 8, enable the communication apparatus to perform the method according to any one of claims 9 to 16, or enable the communication apparatus to perform the method according to any one of claims 17 to 23.

49. A computer-readable storage medium, wherein the storage medium stores a computer program or instructions, and when the computer program or the instructions are executed by a communication apparatus, the method according to any one of claims 1 to 8 is implemented, the method according to any one of claims 9 to 16 is implemented, or the method according to any one of claims 17 to 23 is implemented.

50. A computer program product, wherein the computer program product stores computer-readable instructions, and when the computer-readable instructions run, the method according to any one of claims 1 to 8 is performed, or the method according to any one of claims 9 to 16 is performed, or the method according to any one of claims 17 to 23 is performed.

51. A chip, wherein the chip comprises at least one processor, and the processor is configured to perform the method according to any one of claims 1 to 8, or is configured to perform the method according to any one of claims 9 to 16, or is configured to perform the method according to any one of claims 17 to 23.
